# FASCICULE DE BREVET EUROPEEN

(11) **EP 2 484 191 B1**
(45) Date de publication et mention de la délivrance du brevet: **19.02.2020**
(21) Numéro de dépôt: 10773655.5
(22) Date de dépôt: 29.09.2010
(51) Int. Cl.: H05K 7/20

(54) **BÂTIMENT EXOTHERMIQUE**
EXOTHERMES GEBÄUDE
EXOTHERMIC BUILDING

(30) Priorité: 30.09.2009 FR 0956780
(43) Date de publication de la demande: 08.08.2012
(73) Titulaire: Orange, 75015 Paris (FR)
(72) Inventeur: NORTERSHAUSER, David, F-22300 Ploubezre (FR); LE MASSON, Stéphane, F-22560 Trebeurden (FR); GAUTIER, Jacky, F-22300 Lannion (FR)
(86) Numéro de dépôt international: PCT/FR2010/052042
(87) Numéro de publication internationale: WO 2011/039466

(56) Documents cités:
- JP-A- H07 166 615
- US-A- 4 921 043
- US-A1- 2005 174 733
- US-A1- 2007 115 635
- US-B1- 7 505 269
- NOBORU SUZUKI ET AL: "DEVELOPMENT OF PACKAGE TYPE HEAT STORAGE AIR COOLER (STL PAC) FOR EMERGENCY USE IN TELECOMMUNICATIONS ECUIPMENT ROOMS", PROCEEDINGS OF THE INTERNATIONAL TELECOMMUNICATIONS ENERGY CONFERENCE. (INTELEC). KYOTO, NOV. 5 - 8, 1991; [PROCEEDINGS OF THE INTERNATIONAL TELECOMMUNICATIONS ENERGY CONFERENCE. (INTELEC)], NEW YORK, IEEE, US, vol. CONF. 13, 5 November 1991 (1991-11-05), pages 416-422, XP000314613, ISBN: 978-0-87942-670-5

## Description

L'invention trouve notamment son application dans le domaine des télécommunications, et plus particulièrement de la gestion de l'énergie dans les centres de données.

Un centre de données, ou *datacenter* en terminologie anglo-saxonne, est constitué d'un ou plusieurs bâtiments hébergeant des équipements IT (*Information Technology* ou technologie de l'information en français), tels que des serveurs, nécessaires au fonctionnement de services de type NTIC (Nouvelles Technologies de l'Information et de la Communication) tels que Internet, le commerce électronique, etc.

Les équipements IT hébergés dans les centres de données sont alimentés en énergie électrique nécessaire à leur fonctionnement. Ces équipements IT génèrent, lorsqu'ils sont en fonctionnement, de la chaleur qui se dissipe à l'intérieur du bâtiment. A l'échelle d'un bâtiment, la puissance dissipée par les équipements IT est d'une importance telle que la température atteint en quelques minutes une valeur seuil au-delà de laquelle les équipements IT ne peuvent plus fonctionner. Un tel arrêt du fonctionnement des équipements IT entraine une interruption préjudiciable des services NTIC.

Afin de maintenir la température à l'intérieur des bâtiments en deçà de la valeur seuil au-delà de laquelle les équipements IT ne peuvent plus fonctionner, il est connu d'utiliser un système à production de froid, comme par un exemple un système de climatisation.

Un tel système de conditionnement d'air, en plus de maintenir la température intérieure du bâtiment dans une plage définie, doit assurer le maintien de conditions d'hygrométrie particulières. En effet, les équipements IT ne fonctionnent que dans une plage d'hygrométrie relative donnée, ce qui accroit encore la consommation énergétique des centres de données.

Afin de maintenir des conditions de température et d'hygrométrie permettant le bon fonctionnement des équipements IT, on utilise généralement un système de conditionnement d'air en recyclage. Un tel système refroidit en permanence l'air du bâtiment sans apport d'air neuf depuis l'extérieur.

Conjointement, des systèmes d'humidification/déshumidification sont utilisés pour maintenir l'hygrométrie dans la plage de fonctionnement des équipements IT.

Cependant, l'utilisation d'un système de conditionnement d'air conduit à une consommation énergétique annuelle des centres de données élevée. De plus, un tel système présente l'inconvénient de demander une main d'œuvre spécialisée pour l'entretien et la maintenance, et d'être coûteux en investissement. Enfin, certains systèmes de conditionnement d'air utilisent des fluides frigorigènes nocifs pour l'environnement.

Un des buts de l'invention est de remédier à des inconvénients de l'état de l'art.

A cette fin, l'invention propose un module pour l'hébergement d'au moins un équipement des technologies de l'information générant, lors de son fonctionnement, de la chaleur se dissipant à l'intérieur du module, le module comprenant au moins une paroi composite comprenant, de l'intérieur vers l'extérieur du module :
- une première couche de matériaux conducteurs de chaleur, permettant la déperdition de chaleur de l'intérieur vers l'extérieur du module,
- une deuxième couche de matériaux inerte thermiquement ;
ladite deuxième couche étant séparée de ladite première couche par un espace permettant l'écoulement d'air externe entre lesdites première et deuxième couches et un échange de chaleur par convection entre la première couche et la deuxième couche, l'air externe restant confiné entre la première couche et la deuxième couche sans pénétrer à l'intérieur dudit module;
ledit matériau inerte thermiquement présentant une inertie thermique importante pour stocker du froid durant les périodes au cours desquelles la température de l'air externe introduit est inférieure à la température à l'intérieur du module, pour l'exploiter durant les périodes au cours desquelles la température de l'air externe est supérieure à la température à l'intérieur du module,
ledit module comprenant en outre :
- des moyens d'entrée/sortie d'air externe dans l'espace entre la première et la deuxième couche, lesdits moyens d'entrée/sortie étant aptes à être ouverts ou fermés en fonction de la température extérieure ; et
- des moyens de convection forcée, disposés en entrée ou en sortie des moyens d'entrée/sortie d'air externe, et commandés en fonction de la différence de température entre la température de l'air externe et la température à l'intérieur du module.

Un tel module permet une réduction sensible de la consommation énergétique du fait qu'il n'est plus nécessaire d'utiliser un système de conditionnement d'air avec production de froid pour maintenir la température intérieure du module dans la plage de fonctionnement des équipements IT.

Une telle réduction de la consommation énergétique est rendue possible notamment grâce à l'utilisation de parois composites. En effet, la première couche en matériaux conducteurs de chaleur permet la déperdition de la chaleur excédentaire dissipée à l'intérieur du module par les équipements IT. Le fluide caloporteur permet l'échange de la chaleur entre la première et la deuxième couche. L'inertie thermique est la capacité d'un matériau à absorber puis à restituer la chaleur de manière diffuse.

La deuxième couche grâce à sa capacité à absorber puis à restituer la chaleur avec un délai de plusieurs heures, permet de refroidir le module, même lorsque la température extérieure est supérieure à la température interne du module, par le biais du fluide caloporteur.

Un tel module a un fonctionnement passif, c'est-à-dire qu'il n'est pas besoin d'utiliser des systèmes de refroidissement nécessitant un apport énergétique pour fonctionner.

Ainsi, une telle solution permet de réduire significativement la quantité d'énergie électrique consommée par rapport à l'utilisation d'un système à production de froid. De plus la solution objet de l'invention, ne prévoyant pas l'introduction d'air externe, c'est-à-dire en provenance de l'extérieur du module, à l'intérieur du module où sont situés les équipements IT, limite le risque de dégradation des équipements IT lié à l'introduction de polluants ou de particules provenant de l'extérieur du module.

Les moyens d'entrée/sortie d'air externe comprennent par exemple des registres motorisés ou automatiques. Les moyens de convection forcée comprennent par exemple des ventilateurs.

Selon une caractéristique particulière du module objet de l'invention, la surface d'échange thermique de la première couche est supérieure à la surface projetée de la paroi.

En déployant une première couche présentant une surface d'échange thermique supérieure à la surface projetée de la paroi, il est possible de réaliser un échange de chaleur important avec l'extérieur améliorant ainsi la déperdition de chaleur.

On peut adopter différents profils pour la première couche afin d'augmenter sa surface d'échange thermique tels que par exemple un profil en forme de S, en dents de scies ou encore en créneaux.

Selon une caractéristique particulière du module objet de l'invention, la surface d'échange thermique de la deuxième couche est supérieure à la surface projetée de la paroi.

En déployant une deuxième couche présentant une surface d'échange thermique supérieure à la surface projetée de la paroi, il est possible d'augmenter les échanges de chaleur avec le fluide caloporteur ainsi que la capacité de stockage de la deuxième couche grâce à l'augmentation de volume de matière qui en découle.

Tout comme pour la première couche, on peut adopter différents profils pour la deuxième couche tels que par exemple un profil en forme de S, en dents de scies ou encore en créneaux.

Selon une caractéristique particulière du module objet de l'invention, les matériaux de stockage du froid de la deuxième couche comprennent au moins un produit à changement de phase.

De tels produits sont par exemple de la paraffine, ou des nanomatériaux. En introduisant de tels produits dans la deuxième couche il est possible d'améliorer sensiblement la capacité de stockage du froid de la deuxième couche.

Selon une caractéristique particulière du module objet de l'invention, les matériaux de stockage du froid de la deuxième couche comprennent au moins un produit à changement de phase micro-encapsulé.

Un exemple d'un tel produit est de la paraffine encapsulée dans des billes en matière plastique. Un tel produit qui se mélange facilement au béton peut constituer la deuxième couche.

Selon une caractéristique particulière du module objet de l'invention, les matériaux de stockage du froid de la deuxième couche comprennent des fibres conductrices de la chaleur.

En introduisant des fibres conductrices de la chaleur dans la deuxième couche il est possible d'accroître sa conductivité thermique. Une telle réalisation a pour but d'améliorer les échanges de chaleur entre la deuxième couche et le fluide caloporteur. De telles fibres peuvent par exemple être des fibres métalliques.

Selon une caractéristique particulière du module objet de l'invention, les moyens d'entrée/sortie d'air externe comprennent en outre des moyens de refroidissement de l'air externe préalablement à la convection de l'air externe entre la première et la deuxième couche.

Un tel mode de réalisation permet d'abaisser la température de l'air externe préalablement à son introduction entre la première et la deuxième couche. Ainsi les échanges d'énergie entre ce fluide caloporteur et la première et deuxième couche s'en trouvent favorisés.

De tels moyens de refroidissement de l'air externe étant des moyens peu énergivores, ils ne nécessitent qu'un apport énergétique faible pour fonctionner. Ainsi la solution objet de l'invention est peu consommatrice en énergie et reste avantageuse de ce point de vue par rapport à une solution qui utilise un système à conditionnement d'air.

Selon une caractéristique particulière du module objet de l'invention, la paroi comprend en outre une troisième couche d'un matériau isolant, la troisième couche constituant une interface entre la deuxième couche et l'extérieur du module.Une telle couche de matériau isolant sert d'interface entre la deuxième couche et l'extérieur du module. Une telle couche de matériau isolant permet de limiter significativement le transfert de chaleur depuis l'extérieur du module lorsque la température de l'air externe est supérieure à la température interne du module *et* lorsque le flux solaire incident sur les parois est important.

L'invention concerne également un procédé de contrôle de la température à l'intérieur d'un module tel que le module ci-avant, par évacuation de la chaleur générée par un équipement hébergé dans ce module lors de son fonctionnement, caractérisé en ce que le procédé comprend :
- lorsque la température extérieure est inférieure à une température maximale de fonctionnement de l'équipement, une étape d'ouverture de moyens d'entrée/sortie, depuis l'extérieur du module, d'air externe destiné à s'écouler dans l'espace entre la première et la deuxième couche dudit module ;
- lorsque la température extérieure est supérieure à une température correspondant au seuil en dessous duquel la convection naturelle de l'air externe entre la première et la deuxième couche dudit module est suffisante pour assurer l'évacuation de la chaleur excédentaire vers l'extérieur du module, une étape d'activation des moyens de convection forcée disposés en entrée ou en sortie des moyens d'entrée/sortie d'air externe.

Selon une caractéristique particulière du procédé d'évacuation objet de l'invention, celui-ci comprend, lorsque la température extérieure est supérieure à la température maximale de fonctionnement de l'équipement, une étape de fermeture des moyens de circulation du fluide caloporteur.

Ainsi, lorsque la température de l'air externe est inférieure à la température de l'air à intérieur du module où sont situés les équipements IT, les moyens d'introduction de l'air externe sont activés ainsi que les moyens de circulation de cet air entre la première et la deuxième couche. Lorsque la température de l'air externe est supérieure à la température intérieure maximale autorisée du module où sont situés les équipements IT, les moyens d'introduction de l'air externe sont désactivés, mais les moyens de circulations de l'air entre la première et la deuxième couche sont activés si la température de la deuxième couche est inférieure à la température intérieure du module et si la température de la deuxième couche est inférieure à la température maximale du module.

L'invention concerne encore un bâtiment pour l'hébergement d'au moins un équipement des technologies de l'information générant, lors de son fonctionnement, de la chaleur se dissipant à l'intérieur du bâtiment. Un tel bâtiment est particulier en ce qu'il comprend au moins un module tel que le module ci-avant.

D'autres caractéristiques et avantages apparaîtront à la lecture de modes de réalisation décrits en référence aux dessins dans lesquels :
- la figure 1 représente une paroi d'un module selon un mode de réalisation particulier de l'invention,
- les figures 2A et 2B représentent des exemples de profils que peut présenter la première couche constitutive de la paroi,
- la figure 3 représente une vue en coupe d'un module selon un mode de réalisation de l'invention,
- la figure 4 représente une vue en coupe d'un module selon un autre mode de réalisation de l'invention,
- les figures 5A et 5B représentent un bâtiment destiné à héberger des équipements IT comprenant au moins un module objet de l'invention,
- la figure 6 représente une paroi d'un module selon un autre mode de réalisation de l'invention.

La présente invention concerne un module constitutif d'un bâtiment, tel que par exemple un centre de données, ou bâtiment hébergent un transformateur électrique, en tant que moyen d'évacuer l'énergie calorifique dissipée par des équipements IT hébergés dans le module, tout en minimisant les apports de chaleur depuis l'extérieur du module.

Une telle solution permet de réduire significativement l'énergie consommée pour le maintien des équipements dans leurs plages de températures de fonctionnement tout en limitant l'introduction de poussières et polluants à l'intérieur du module.

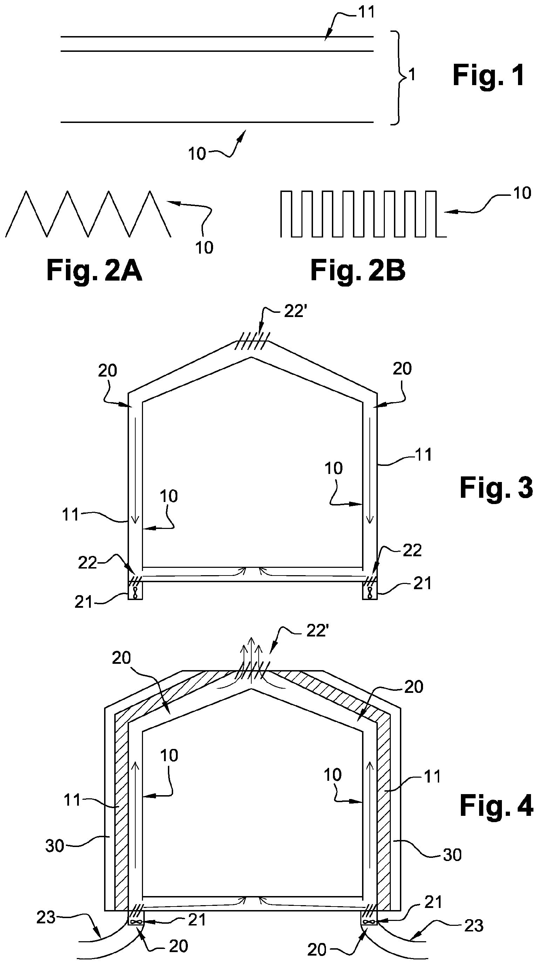

La **figure 1** représente une paroi 1 d'un tel module. Une telle paroi 1 est une paroi composite comprenant, de l'intérieur vers l'extérieur du module :
- une première couche 10 constituée de matériaux conducteurs de chaleur permettant la déperdition de la chaleur générée par les équipements IT vers l'extérieur du module, et
- une deuxième couche 11 constituée de matériaux permettant le stockage du froid.

L'utilisation de matériaux conducteurs de chaleur permettant la déperdition de la chaleur dans la constitution de la première couche 10 de la paroi 1 du module permet d'augmenter les déperditions de chaleur depuis l'intérieur vers l'extérieur du module. Afin d'obtenir un résultat intéressant, il est nécessaire que la température d'introduction de l'air externe soit inférieure à la température intérieure du module un pourcentage important du temps. Ainsi, le module est souvent apte à céder de la chaleur vers l'extérieur dans certaines conditions de température.

Dans un mode de réalisation de l'invention, la première couche 10 est par exemple réalisée en acier galvanisé ou encore en aluminium.

Afin d'augmenter les échanges de chaleur avec l'extérieur, la surface d'échange thermique de la première couche 10 est augmentée de sorte à être rendue supérieure à la surface projetée de la paroi 1. Pour ce faire, la première couche 10 présente un profil en dents de scie tel que représenté à la **figure 2A****.** Dans un autre mode de réalisation, la couche 10 présente un profil en forme de créneaux tel que représenté à la **figure 2B**. La couche 10 peut présenter d'autres profils tels qu'un profil en S par exemple.

L'utilisation de matériaux permettant le stockage du froid dans la constitution de la deuxième couche 11 de la paroi 1 du module permet de limiter les apports de chaleur qui se produisent lorsque la température de l'air externe est supérieure à la température intérieure du module.

Dans un mode de réalisation particulier de l'invention, la deuxième couche 11 est constituée d'une épaisseur de béton ou de matériaux présentant une inertie thermique importante tels que parpaings, pierres, etc. Plus précisément, il s'agit de stocker du froid durant les périodes au cours desquelles la température de l'air externe introduit est inférieure à la température intérieure pour l'exploiter durant les périodes au cours desquelles la température de l'air externe est supérieure à la température intérieure.

Lorsque la température de l'air externe introduit est supérieure à la température intérieure du module, il est possible d'échanger la chaleur entre la première couche 10 et la deuxième couche 11. Ceci revient à utiliser la deuxième couche 11 comme un réservoir de stockage de froid.

Dans un mode de réalisation de l'invention, on augmente la surface d'échange entre la première couche 10 et la deuxième couche 11 en adoptant, pour la deuxième couche 11 un profil identique à celui de la première couche 10. Ainsi, la deuxième couche 11 présente par exemple un profil en dents de scies, en créneaux ou en S, ceci en fonction du profil de la première couche 10.

Dans un premier mode de réalisation de l'invention, il est possible d'augmenter sensiblement l'inertie thermique de la deuxième couche 11 en y intégrant des produits à changement de phase. Il peut s'agir par exemple de paraffine enfermée dans des capsules de petites taille (diamètre inférieur au millimètre). En effet, grâce à l'exploitation de la chaleur latente de ces produits, la capacité de stockage thermique de la deuxième couche 11 s'en trouve fortement augmentée.

Dans un deuxième mode de réalisation de l'invention, la deuxième couche comprend des fibres conductrices de la chaleur permettant d'accroître sa conductivité thermique. De telles fibres sont par exemple des fibres métalliques ou encore des nanomatériaux.

Dans un mode de réalisation de l'invention, la paroi 1 comprend une troisième couche isolante 30 présentant une forte résistance thermique (représentée sur **la** **figure** 4) servant d'interface avec l'extérieur. Une telle couche 30 permet de limiter les apports de chaleur depuis l'extérieur vers l'intérieur du module.

En référence à la **figure 3**, l'espace entre la première couche 10 et la deuxième couche 11 permet un écoulement d'un fluide caloporteur 20. Dans un mode de réalisation de l'invention, le fluide caloporteur 20 est l'air externe. Dans un autre mode, le fluide caloporteur est l'eau. Dans un tel mode de réalisation, il est nécessaire d'ajouter des conduites destinées à transporter l'eau. De telles conduites sont noyées dans le matériau constitutif deuxième couche. Dans un mode de réalisation, des nanoparticules peuvent être diluées dans l'eau afin d'améliorer les propriétés thermodynamiques de l'eau.

L'air externe 20 est introduit entre la première couche 10 et la deuxième couche 11 à l'aide de moyens de circulation d'air 22. De tels moyens de circulation d'air 22 sont par exemple disposés au niveau du sol du module permettant ainsi l'introduction de l'air externe 20 par le bas. Ceci favorise la convection naturelle de l'air externe 20 entre la première couche 10 et la deuxième couche 11. En effet, la majeure partie du temps, l'air externe 20 pénétrant entre les couches 10 et 11 a une température inférieure à l'air externe déjà présent entre les couches 10 et 11. Par convection naturelle, l'air externe déjà présent entre les couches 10 et 11 plus chaud est déplacé vers le sommet du module par l'air externe 20 pénétrant entre les couches 10 et 11. L'air externe déjà présent entre les couches 10 et 11 est alors évacué au travers d'une ouverture 22' pratiquée au sommet du module.

Il convient de s'assurer que l'air externe 20 ne pénètre pas à l'intérieur du module où sont situés les équipements IT afin de ne pas y introduire de poussières et de polluants. L'air externe 20 reste confiné entre la première couche 10 et la deuxième couche 11.

Les écoulements de fluide caloporteur entre les couches 10 et 11 sont générés par des moyens pour assurer une convection forcée 21 tels que des ventilateurs lorsque le fluide caloporteur est l'air externe ou des turbines ou des pompes lorsque le fluide caloporteur est l'eau, commandés en fonction de la différence entre la température de l'air externe et la température à l'intérieur du module. De tels moyens pour assurer une convection forcée sont disposés en entrée ou en sortie des moyens de circulation d'air 22.

Ainsi, tant que la température de l'air externe est inférieure à une température Td, correspondant au seuil en dessous duquel la convection naturelle de l'air externe 20 entre les deux couches 10 et 11 est suffisante pour assurer l'évacuation de la chaleur excédentaire vers l'extérieur du module, les moyens pour assurer une convection forcée 21 ne sont pas activés. De même, les moyens de circulation d'air 22 et l'ouverture 22' sont ouverts.

Lorsque la température de l'air externe est supérieure à la température Td, les moyens pour assurer une convection forcée 21 sont activés. Le débit de la convection forcée varie alors linéairement pour des températures externes allant de Td à la température optimale de fonctionnement des équipements IT. Dans un tel cas de figure les moyens de circulation d'air 22 et l'ouverture 22' sont ouverts.

Lorsque la température de l'air externe est supérieure à la température maximale de fonctionnement des équipements IT, tout apport d'air externe 20 doit être stoppé. Les moyens de circulation d'air 22 et l'ouverture 22.

L'écoulement de l'air externe 20 entre les couches 10 et 11 conduit à améliorer l'échange de chaleur par convection entre la première couche 10 et la deuxième couche 11.

Du fait de la forte inertie thermique des matériaux constituant la deuxième couche 11, la deuxième couche 11 voit sa température diminuer avec la température extérieure, notamment la nuit. La deuxième couche 11 peut alors recevoir de l'énergie thermique du fluide caloporteur lorsque la température de l'air externe est supérieure à la température Td.

Suivant un autre mode de réalisation de l'invention représenté à la **figure 4**, des conduites souterraines 23, occasionnant un pré-refroidissement de l'air externe 20 peuvent être utilisées. Dans ce cas, la variation du débit de la convection forcée tient compte du pré-refroidissement de l'air externe 20. De telles conduites 23 sont connectées aux moyens de circulation d'air 22.

De telles conduites 23 sont, par exemple, fabriquées dans un matériau présentant une forte inertie thermique tel que du béton. Le matériau constitutif des conduites 23 comprend, dans un mode de réalisation de l'invention, des matériaux à changement de phase. La température de changement de phase est dans ce cas inférieure de quelques degrés à la température optimale de fonctionnement des équipements IT.

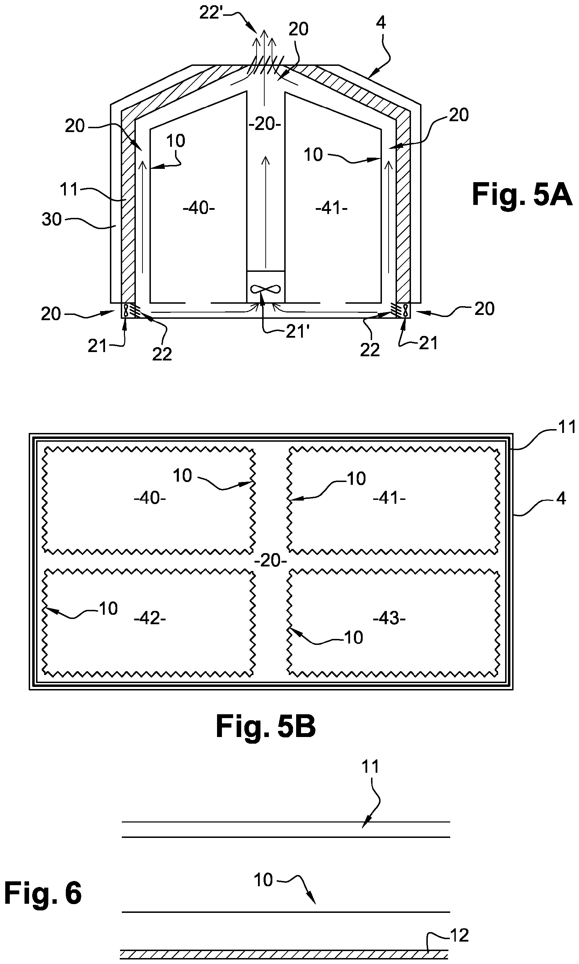

La **figure 6** représente une paroi 1' selon un autre mode de réalisation de l'invention. Une telle paroi 1' comprend, de l'intérieur vers l'extérieur du module :
- une couche isolante 12,
- la couche 10 constituée de matériaux conducteurs de chaleur permettant la déperdition de la chaleur générée par les équipements IT vers l'extérieur du module, et
- la deuxième couche 11 constituée de matériaux permettant le stockage du froid.

L'espace entre la couche 10 et la couche 11 et l'espace entre la couche 12 et la couche 10 permettent un écoulement du fluide caloporteur 20.

Cela permet de favoriser les échanges de chaleur entre l'air chaud venant des équipements IT hébergés à l'intérieur du module et la première couche 10.

L'invention concerne également un bâtiment comprenant plusieurs modules tels que décrit précédemment. Un tel bâtiment 4 est représenté à la **figure 5A**. Le bâtiment 4 comprend deux modules 40, 41 constitués chacun par une couche 10. La couche 11 constitue l'enceinte du bâtiment 4 avec la couche isolante 30.

L'air externe 20 est introduit entre les couches 10 et 11 à l'aide des moyens de circulation d'air 22 disposés au bas du bâtiment 4. En fonction des conditions de température, l'air externe est soumis à une convection forcée assurée par des moyens pour assurer une convection forcée 21. Ces moyens pour assurer une convection forcée 21 sont disposés à proximité des moyens de circulation d'air 22 afin d'optimiser la circulation de l'air externe entre les couches 10 et 11. Des moyens pour assurer une convection forcée 21' de l'air externe 20 sont disposés entre les deux modules 40 et 41 afin de faciliter la circulation de l'air externe 20 entre les modules et ainsi favoriser l'évacuation de la chaleur. L'air externe circulant entre les couches 10 et 11 et les modules 40 et 41 est alors évacué au travers de l'ouverture 22' pratiquée au sommet du bâtiment 4.

La **figure 5B** représente une vue en coupe du bâtiment 4. Dans une telle réalisation, le bâtiment 4 comporte quatre modules 40, 41, 42 et 43. La deuxième couche 11 est constituée par les murs du bâtiment 4.

Une telle réalisation permet d'augmenter les déperditions de chaleur vers l'extérieur par rapport à une situation dans laquelle le bâtiment 4 comporte un unique module.
L'invention concerne également un procédé de mise à niveau d'un bâtiment hébergeant des équipements IT. Un tel procédé consiste à assembler, à l'intérieur du bâtiment, les parois constituant les différents modules 40, 41, 42 et 43. Dans une telle réalisation la deuxième couche 11 est constituée par les murs du bâtiment 4.

## Revendications

1. Module pour l'hébergement d'au moins un équipement des technologies de l'information générant, lors de son fonctionnement, de la chaleur se dissipant à l'intérieur du module, le module comprenant au moins une paroi composite (1) comprenant, de l'intérieur vers l'extérieur du module :
• une première couche (10) de matériaux conducteurs de chaleur, permettant la déperdition de chaleur de l'intérieur vers l'extérieur du module,
• une deuxième couche (11) de matériaux inerte thermiquement ;
ladite deuxième couche (11) étant séparée de ladite première couche (10) par un espace permettant l'écoulement d'air externe (20) entre lesdites première et deuxième couches (10,11) et un échange de chaleur par convection entre la première couche (10) et la deuxième couche (11), l'air externe restant confiné entre la première couche (10) et la deuxième couche (11) sans pénétrer à l'intérieur dudit module;
ledit matériau inerte thermiquement présentant une inertie thermique importante pour stocker du froid durant les périodes au cours desquelles la température de l'air externe introduit est inférieure à la température à l'intérieur du module, pour l'exploiter durant les périodes au cours desquelles la température de l'air externe est supérieure à la température à l'intérieur du module,
ledit module comprenant en outre :
- des moyens d'entrée/sortie (22,22') de l'air externe dans l'espace entre la première et la deuxième couche, lesdits moyens d'entrée/sortie étant aptes à être ouverts ou fermés en fonction de la température extérieure ; et
- des moyens de convection forcée (21), disposés en entrée ou en sortie des moyens d'entrée/sortie (22,22') d'air externe, et commandés en fonction de la différence de température entre la température de l'air externe et la température à l'intérieur du module.

2. Module selon la revendication 1, dans lequel la surface d'échange thermique de la première couche est supérieure à la surface projetée de la paroi.

3. Module selon la revendication 1, dans lequel dans lequel la surface d'échange thermique de la deuxième couche est supérieure à la surface projetée de la paroi.

4. Module selon la revendication 1, dans lequel les matériaux de stockage du froid de la deuxième couche comprennent au moins un produit à changement de phase.

5. Module selon la revendication 1, dans lequel les moyens d'entrée/sortie (22,22') d'air externe comprennent en outre des moyens de refroidissement de l'air externe préalablement à son introduction dans le module.

6. Module selon la revendication 1, dans lequel la paroi comprend en outre une troisième couche (30) d'un matériau isolant, la troisième couche constituant une interface entre la deuxième couche et l'extérieur du module.

7. Procédé de contrôle de la température à l'intérieur d'un module selon la revendication 1, par évacuation de la chaleur générée par un équipement hébergé dans ledit module lors de son fonctionnement, **caractérisé en ce que** le procédé comprend :
- lorsque la température extérieure est inférieure à une température maximale de fonctionnement de l'équipement, une étape d'ouverture de moyens d'entrée/sortie (22,22'), depuis l'extérieur du module, d'air externe destiné à s'écouler dans l'espace entre la première et la deuxième couche dudit module ;
- lorsque la température extérieure est supérieure à une température correspondant au seuil en dessous duquel la convection naturelle de l'air externe entre la première et la deuxième couche dudit module est suffisante pour assurer l'évacuation de la chaleur excédentaire vers l'extérieur du module, une étape d'activation des moyens de convection forcée (21) disposés en entrée ou en sortie des moyens d'entrée/sortie (22,22') d'air externe.

8. Procédé d'évacuation selon la revendication 7 comprenant, lorsque la température extérieure est supérieure à la température maximale de fonctionnement de l'équipement, une étape de fermeture des moyens d'entrée/sortie (22,22') d'air externe.

9. Bâtiment (4) pour l'hébergement d'au moins un équipement des technologies de l'information générant, lors de son fonctionnement, de la chaleur se dissipant à l'intérieur du bâtiment, **caractérisé en ce que** le bâtiment comprend au moins un module selon l'une des revendications 1 à 6.

## Patentansprüche

1. Modul zur Unterbringung mindestens eines Geräts der Informationstechnologien, das während seines Betriebs Wärme erzeugt, die in den Innenbereich des Moduls abgegeben wird, wobei das Modul mindestens eine Verbundwand (1) umfasst, die vom Innenbereich zum Außenbereich des Moduls umfasst:
• eine erste Schicht (10) aus wärmeleitenden Materialien, welche die Abgabe von Wärme vom Innenbereich zum Außenbereich des Moduls ermöglicht,
• eine zweite Schicht (11) aus thermisch trägen Materialien;
wobei die zweite Schicht (11) von der ersten Schicht (10) durch einen Raum getrennt ist, der das Strömen von Außenluft (20) zwischen der ersten und der zweiten Schicht (10, 11) und einen Wärmeaustausch durch Konvektion zwischen der ersten Schicht (10) und der zweiten Schicht (11) ermöglicht, wobei die Außenluft zwischen der ersten Schicht (10) und der zweiten Schicht (11) eingeschlossen bleibt, ohne in den Innenbereich des Moduls einzudringen;
wobei das thermisch träge Material eine hohe thermische Trägheit aufweist, um während der Zeiten, in denen die Temperatur der zugeführten Außenluft geringer als die Temperatur im Innenbereich des Moduls ist, Kälte zu speichern, um sie während der Zeiten zu nutzen, in denen die Temperatur der Außenluft über der Temperatur im Innenbereich des Moduls liegt,
wobei das Modul ferner umfasst:
- Einrichtungen zum Einlassen/Auslassen (22, 22') der Außenluft in dem Raum zwischen der ersten und der zweiten Schicht, wobei die Einrichtungen zum Einlassen/Auslassen geeignet sind, in Abhängigkeit von der Außentemperatur geöffnet oder geschlossen zu werden; und
- Zwangskonvektionseinrichtungen (21), die im Einlass oder im Auslass der Einrichtungen zum Einlassen/Auslassen (22, 22') von Außenluft angeordnet sind und die in Abhängigkeit von der Temperaturdifferenz zwischen der Temperatur der Außenluft und der Temperatur im Innenbereich des Moduls gesteuert werden.

2. Modul nach Anspruch 1, bei dem die Wärmeaustauschfläche der ersten Schicht größer als die projizierte Fläche der Wand ist.

3. Modul nach Anspruch 1, bei dem die Wärmeaustauschfläche der zweiten Schicht größer als die projizierte Fläche der Wand ist.

4. Modul nach Anspruch 1, bei dem die Kältespeichermaterialien der zweiten Schicht mindestens ein Phasenwechselprodukt umfassen.

5. Modul nach Anspruch 1, bei dem die Einrichtungen zum Einlassen/Auslassen (22, 22') von Außenluft ferner Einrichtungen zur Kühlung der Außenluft vor ihrer Einführung in das Modul umfassen.

6. Modul nach Anspruch 1, bei dem die Wand ferner eine dritte Schicht (30) aus einem isolierenden Material umfasst, wobei die dritte Schicht eine Schnittstelle zwischen der zweiten Schicht und dem Außenbereich des Moduls bildet.

7. Verfahren zur Regelung der Temperatur im Innenbereich eines Moduls nach Anspruch 1 durch Abführen der von einem in dem Modul untergebrachten Gerät bei dessen Betrieb erzeugten Wärme, **dadurch gekennzeichnet, dass** das Verfahren umfasst:
- wenn die Außentemperatur unter einer maximalen Betriebstemperatur des Geräts liegt, einen Schritt des Öffnens der Einrichtungen zum Einlassen/Auslassen (22, 22'), vom Außenbereich des Moduls, von Außenluft, die dazu bestimmt ist, in den Raum zwischen der ersten und der zweiten Schicht des Moduls zu strömen;
- wenn die Außentemperatur über einer Temperatur liegt, die dem Schwellenwert entspricht, unter dem die natürliche Konvention der Außenluft zwischen der ersten und der zweiten Schicht des Modus ausreicht, um das Abführen der überschüssigen Wärme zum Außenbereich des Moduls zu gewährleisten, einen Schritt des Aktivierens der Zwangskonvektionseinrichtungen (21), die im Einlass oder im Auslass der Einrichtungen zum Einlassen/Auslassen (22, 22') von Außenluft angeordnet sind.

8. Verfahren zum Abführen nach Anspruch 7, das, wenn die Außentemperatur über der maximalen Betriebstemperatur des Geräts liegt, einen Schritt des Schließens der Einrichtungen zum Einlassen/Auslassen (22, 22') von Außenluft umfasst.

9. Gebäude (4) zur Unterbringung mindestens eines Geräts der Informationstechnologien, das während seines Betriebs Wärme erzeugt, die in den Innenbereich des Gebäudes abgegeben wird, **dadurch gekennzeichnet, dass** das Gebäude mindestens ein Modul nach einem der Ansprüche 1 bis 6 umfasst.

## Claims

1. Module for hosting at least one information technologies equipment item generating, in its operation, heat that is dissipated inside the module, the module comprising at least one composite wall (1) comprising, from the inside to the outside of the module:
• a first layer (10) of heat-conducting materials, allowing heat loss from the inside to the outside of the module,
• a second layer (11) of thermally inert materials;
said second layer (11) being separated from said first layer (10) by a space allowing the flow of outside air (20) between said first and second layers (10, 11) and an exchange of heat by convection between the first layer (10) and the second layer (11), the outside air remaining contained between the first layer (10) and the second layer (11) without penetrating inside said module;
said thermally inert material having a significant thermal inertia for storing cold during periods during which the temperature of the outside air introduced is below the temperature inside the module, to exploit it during the periods during which the temperature of the outside air is higher than the temperature inside the module,
said module further comprising:
- input/output means (22, 22') for the outside air in the space between the first layer and the second layer, said input/output means being capable of being opened or closed as a function of the outside temperature; and
- forced convection means (21), disposed at the input or at the output of the outside air input/output means (22, 22'), and controlled as a function of the temperature difference between the temperature of the outside air and the temperature inside the module.

2. Module according to Claim 1, wherein the heat exchange surface of the first layer is greater than the projected surface of the wall.

3. Module according to Claim 1, wherein the heat exchange surface of the second layer is greater than the projected surface of the wall.

4. Module according to Claim 1, wherein the cold storage materials of the second layer comprise at least one phase-change product.

5. Module according to Claim 1, wherein the outside air input/output means (22, 22') further comprise means for cooling the outside air prior to its introduction into the module.

6. Module according to Claim 1, wherein the wall further comprises a third layer (30) of an insulating material, the third layer forming an interface between the second layer and the outside of the module.

7. Method for controlling the temperature inside a module according to Claim 1, by evacuation of the heat generated by an equipment item hosted in said module in its operation, **characterized in that** the method comprises:
- when the outside temperature is lower than a maximum operating temperature of the equipment item, a step of opening of input/output means (22, 22'), from the outside of the module, for outside air intended to flow in the space between the first layer and the second layer of said module;
- when the outside temperature is higher than a temperature corresponding to the threshold below which the natural convection of the outside air between the first layer and the second layer of said module is sufficient to ensure the evacuation of the excess heat to the outside of the module, a step of activation of the forced convection means (21) disposed at the input or at the output of the outside air input/output means (22, 22').

8. Evacuation method according to Claim 7 comprising, when the outside temperature is higher than the maximum operating temperature of the equipment item, a step of closure of the outside air input/output means (22, 22').

9. Building (4) for hosting at least one information technologies equipment item generating, in its operation, heat that is dissipated inside the building, **characterized in that** the building comprises at least one module according to one of Claims 1 to 6.
